Europäisches Patentamt

European Patent Office

Office européen des brevets

(11) Veröffentlichungsnummer: **0 418 545 A2**

# EUROPÄISCHE PATENTANMELDUNG

(21) Anmeldenummer: 90115404.7

(22) Anmeldetag: **10.08.90**

(51) Int. Cl.5: **H03K 17/08**

(30) Priorität: **22.09.89 DE 3931729**

(43) Veröffentlichungstag der Anmeldung:
**27.03.91 Patentblatt 91/13**

(84) Benannte Vertragsstaaten:
**CH DE ES FR GB IT LI SE**

(71) Anmelder: **TRANSTECHNIK GMBH**
**Otterfinger Weg 11**
**W-8150 Holzkirchen(DE)**

(72) Erfinder: **Hofgräff, Hans. G**
**Franz-Obermayr-Strasse 11**
**W-8150 Holzkirchen(DE)**

(74) Vertreter: **Bohnenberger, Johannes, Dr. et al**
**Meissner, Bolte & Partner**
**Widenmayerstrasse 48 Postfach 86 06 24**
**W-8000 München 86(DE)**

(54) **Elektrische Schaltung zur Ausschaltentlastung eines steuerbaren Halbleiterschalters.**

(57) Es sind elektrische Schaltungen zur Ausschaltentlastung steuerbarer Halbleiterschalter, insbesondere abschaltbarer Thyristoren bekannt, bei denen eine Reihenschaltung aus einem Speicherkondensator und einer Diode parallel zum Schalter angeordnet ist. Über eine Steuerschaltung wird ein Entladungsschalter angesteuert, der einen Entladungsstromkreis schließt, welcher den Kondensator mit der Primärwicklung eines Transformators verbindet, so daß an einer Sekundärwicklung des Transformators die im Kondensator gespeicherte elektrische Energie abnehmbar ist. Es wird vorgeschlagen, die Steuerschaltung derart auszubilden und mit der Diode eingangsseitig zu verbinden, daß der Entladungsschalter in Abhängigkeit von der Polarität der Spannung an der Diode geschaltet wird. Der Transformator wird vorzugsweise als Sperrwandler betrieben.

Fig. 1

EP 0 418 545 A2

## ELEKTRISCHE SCHALTUNG ZUR AUSSCHALTENTLASTUNG EINES STEUERBAREN HALBLEITERSCHALTERS

Die Erfindung betrifft eine elektrische Schaltung zur Ausschaltentlastung eines steuerbaren Halbleiters, insbesondere eines abschaltbaren Tyristors (GTO) nach dem Oberbegriff des Patentanspruches 1.

Es ist bekannt, daß steuerbare Halbleiter, insbesondere GTO's dann, wenn sie induktiv belastet sind, eine Ausschaltentlastung zur Begrenzung der Spannungsanstiegsgeschwindigkeit beim Abschalten benötigen. Die hierbei anfallende Energie kann bei hohen Schaltfrequenzen nicht mehr auf einfache Weise abgeführt werden, vielmehr müssen aktive Ausschalt-Entlastungsnetzwerke vorgesehen werden. Bei Gleichstromstellern bzw. -reglern lohnt sich die Rückführung der beim.Abschalten im Kondensator gespeicherten Energie in den Verbraucher oder ins Netz.

Eine elektrische Schaltung der eingangs genannten Art ist aus der DEZ Elektrische Energie-Technik, 1985, Nr. 1, Seiten 36-41 bekannt. Bei dieser bekannten Schaltung ist der Speicherkondensator über eine Diode und einen weiteren abschaltbaren Thyristor mit der Primärwicklung eines Transformators verbunden, der sekundärseitig über eine Brückengleichrichterschaltung mit einem Stromverbraucher, nämlich einer Betriebsspannungsquelle (Gleichspannungszwischenkreis) verbunden ist. In einem der Brückenzweige des Gleichrichters ist eine Induktivität vorgesehen. Weiterhin ist eine, die Reihenschaltung aus Primärwicklung und zweitem GTO verbindende Freilaufdiode vorgesehen Bei der bekannten Schaltung wird der zweite GTO synchron zum ersten GTO eingeschaltet Die Abschaltung soll dann erfolgen, wenn der Speicherkondensator entladen ist Wenn der zweite GTO durchgesteuert wird, so fließt ein Entladestrom durch die Primärwicklung des Transformators, so daß ein entsprechender Sekundärstrom im Sekundärkreis durch den Brückengleichrichter fließt Sobald der zweite GTO abgeschaltet wird, entlädt sich die aufgrund der Induktivität der Primärwicklung des Transformators gespeicherte Energie durch die Freilaufdiode. Sekundärseitig fließt dann ein Strom durch den anderen Brückenzweig des dort vorgesehenen Gleichrichters

Bei der bekannten Anordnung wird es als nachteilig angesehen, daß eine, in der Druckschrift nicht näher beschriebene aber bekanntlich aufwendige Ansteuerschaltung für den zweiten GTO notwendig ist. Dieser zweite GTO muß dieselbe Sperrspannung wie der erste GTO aufweisen Darüber hinaus sind die Möglichkeiten zur Rückspeisung der im Kondensator gespeicherten Energie bei der bekannten Schaltung begrenzt.

Der Erfindung liegt die Aufgabe zugrunde, eine elektrische Schaltung der eingangs genannten Art dahingehend weiterzubilden, daß bei vereinfachtem Aufbau eine verbesserte Energierückspeisung ermöglicht wird.

Diese Aufgabe wird durch die im Kennzeichen des Patentanspruches angegebenen Merkmale gelöst.

Ein wesentlicher Punkt der Erfindung liegt also darin, daß durch die Ansteuerung des Entladungsschalters in Abhängigkeit von der Polarität der Spannung an der ersten Diode ein selbsttätiges Abschalten des Entladungsschalters bei entladenem Kondensator und ein selbsttätiges Anschalten des Entladeschalters bei Anschalten des steuerbaren Halbleiterschalters erfolgt. Solange nämlich der steuerbare Halbleiterschalter offen ist, liegt im wesentlichen nur eine vernachlässigbare Restspannung an der ersten Diode vor. Sobald der steuerbare Halbleiterschalter durchsteuert, liegt die volle Spannung des Speicherkondensators über der ersten Diode. Sobald der Kondensator entladen ist und der Stromfluß aufgrund der Induktivität der Primärwicklung des Transformators weiter aufrechterhalten wird, kehrt sich die Polarität der Spannung an der Diode um, so daß dadurch der Entladungsschalter geöffnet werden kann.

Vorzugsweise wird der Transformator (sekundärseitig) als Sperrwandler beschaltet, so daß bei geschlossenem Entladungsschalter die im Kondensator gespeicherte Energie in der Primärwicklung des Transformators gespeichert und beim Öffnen des Entladungsschalters sekundärseitig abgegeben wird. Dies ist durch eine Einweg-Gleichrichterschaltung möglich. Die Induktivität der Primärspule, die Kapazität des Kondensators und die Mindest-Einschaltzeit des steuerbaren Halbleiterschalters sind so aufeinander abgestimmt, daß ein sicheres Entladen des Kondensators während der (Mindest-) Einschaltzeit des steuerbaren Halbleiterschalters erfolgen kann. Vorzugsweise ist der Entladungsschalter als MOSFET ausgebildet.

Weitere wesentliche Merkmale ergeben sich aus den Unteransprüchen und der nachfolgenden Beschreibung bevorzugter Ausführungsformen der Erfindung. Diese werden anhand von Abbildungen näher erläutert. Hierbei zeigen:

Fig. 1 eine Prinzip-Schaltung einer Ausführungsform der Erfindung und

Fig. 2 ein Schaltbild einer bevorzugten Ausführrungsform der Erfindung.

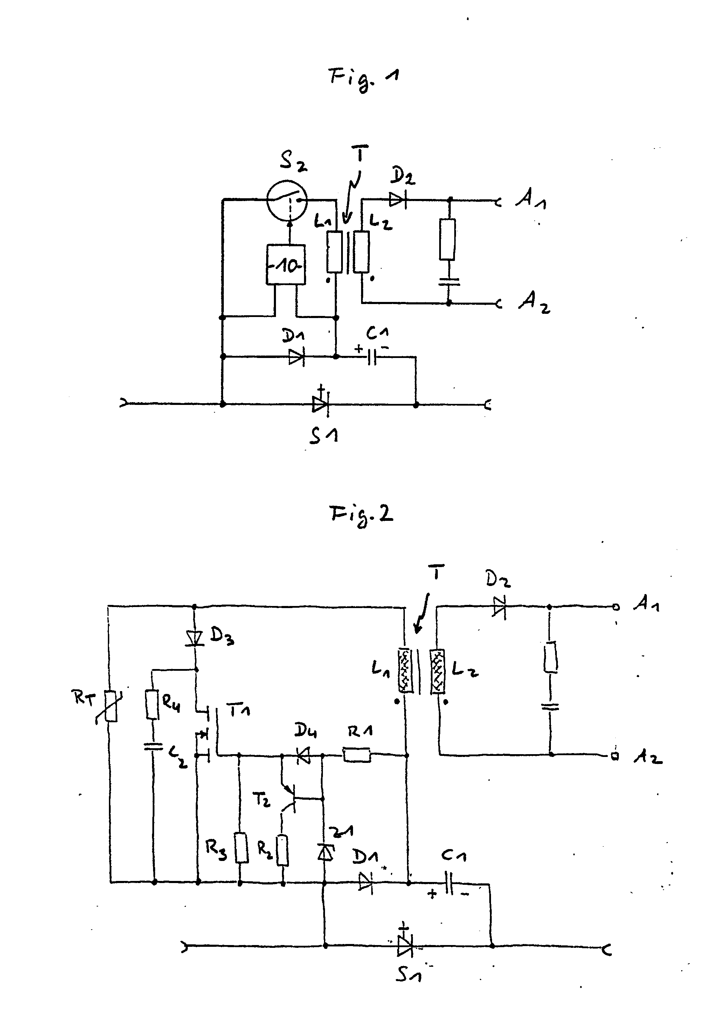

In Fig. 1 ist mit S1 ein steuerbarer Halbleiterschalter gezeigt, der - wie aus dem Schaltsymbol ersichtlich - als GTO ausgebildet ist. Parallel zum GTO ist eine Reihenschaltung, bestehend aus einer ersten Diode D1 und einem Speicherkondensator C1 angeordnet. Die Kathode der ersten Diode D1 ist mit der einen Klemme einer Primärwicklung L1 eines Transformators T verbunden, deren andere Klemme über einen Entladungsschalter S2 mit der Anode der ersten Diode D1 verbunden ist. Der Entladungsschalter S2 wird über eine Steuerschaltung 10 geöffnet und geschlossen, die mit ihren Steuereingängen parallel zur ersten Diode D1 geschaltet ist und auf diese Weise die an der ersten Diode D1 liegende Spannung abtasten kann.

Der Transformator T liegt mit einer Klemme seiner Sekundärwicklung L2 an der Anode einer zweiten Diode D2, deren Kathode mit einer Ausgangsklemme A2 verbunden ist. Die andere Klemme der Sekundärwicklung L2 ist mit einer anderen Ausgangsklemme A2 verbunden. Zwischen den Ausgangsklemmen A1 und A2 liegt eine Reihenschaltung aus einem Kondensator und einem Widerstand.

Die Steuerschaltung 10 ist so ausgebildet, daß dann, wenn die erste Diode D1 in Sperrichtung vorgespannt ist, der Schalter S2 geschlossen und dann, wenn aufgrund entsprechender Spannungsverhältnisse ein Strom durch die Diode D1 zu fließen beginnt, der Schalter S2 geöffnet wird.

Weiterhin sind die Wicklungen des Transformators T in der in Fig. 1 gezeigten Weise beschaltet, so daß sekundärseitig dann ein Strom in eine an den Ausgangsklemmen A1, A2 angeschlossene Last durch Entladung der gespeicherten Energie fließt, wenn der primärseitige Stromkreis durch Öffnen des Schalters S2 unterbrochen wird. Der Transformator T arbeitet somit als Sperrwandler.

Die Funktionsweise der Anordnung ist derart, daß beim Abschalten des GTO S1 der Kondensator C1 über die Diode D1 mit der in Fig. 1 gezeigten Polarität bei einem definierten Spannungsanstieg aufgeladen wird. Wird nun der GTO S1 eingeschaltet, so wird die Anode der Diode D1 über den GTO S1 mit der auf negativem Potential liegenden Klemme des Kondensators C1 verbunden. Somit liegt eine die Diode D1 in Sperrichtung beaufschlagende Spannung an den Eingangsklemmen der Steuerschaltung 10. Daraufhin schließt diese den Entladungsschalter S2, so daß der Kondensator C1 über die Primärwicklung L1 des Transformators T, den Schalter S2 und den GTO S1 entladen wird. Aufgrund der Diode D2 kann im Sekundärkreis des Transformators T2 kein Strom fließen. Somit wirkt die Primärspule L1 des Transformators T als Drossel mit definierter Induktivität.

Wenn der Kondensator C1 entladen ist, seine Spannung also im wesentlichen auf Null abgesunken ist, fließt aufgrund der Induktivität des Transformators T bzw. der Primärspule L1 der Strom über D1 weiter, so daß nunmehr an der Diode D1 eine Spannung mit entgegengesetzter Richtung liegt. Diese von der Steuerschaltung 10 abgetastete Spannung führt nun dazu, daß der Schalter S2 geöffnet wird. Nunmehr kann die im Transformator T gespeicherte Energie einen Stromfluß in Durchlaßrichtung der Diode D2 im Sekundärkreis des Transformators T erzeugen, so daß die vom Kondensator C1 in den Transformator T übertragene Energie an den Verbraucher abgegeben werden kann, der an den Klemmen A1, A2 liegt.

Der an den Ausgangsklemmen A1, A2 liegende Verbraucher kann das Primärnetz sein, da der Transformator T als Sperrwandler geschaltet ist.

Im folgenden wird eine bevorzugte, konkrete Ausführungsform der Erfindung anhand von Fig. 2 näher erläutert.

Wie in der Abbildung dargestellt, ist der Schalter S1 wie bei der zuvor gezeigten Ausführungsform mittels einer Reihenschaltung aus einer Diode D1 und einem Entladekondensator C1 überbrückt. Hierbei ist die Anode der Diode D1 mit der Anode des GTO S1 verbunden.

Die Kathode der Diode D1 ist mit der einen Klemme einer Primärwicklung L1 eines Transformators T verbunden, deren andere Klemme an der Anode einer Diode D3 liegt, die mit ihrer Kathode am Drain-Anschluß eines (Enhancement-N-Kanal) MOSFET T1 liegt. Der Source-Anschluß des MOSFET T1 liegt an der Anode der Diode D1.

Zum Schutz des MOSFET T1 ist seine Drain-Source-Strecke mittels einer RC-Reihenschaltung überbrückt. Darüber hinaus ist die Reihenschaltung bestehend aus dem MOSFET T1 und der vorgeschalteten Diode D3 von einem Varistor in an sich bekannter Weise überbrückt.

Der Gate-Anschluß des MOSFET T1 liegt an der Kathode einer Diode D4, deren Anode über einen Widerstand R1 an die Kathode der Diode D1 gelegt ist. Am Verbindungspunkt zwischen der Diode D4 und dem Widerstand R1 liegt die Kathode einer Zenerdiode Z1, deren Anode mit der Anode der Diode D1 verbunden ist. Weiterhin liegt ein pnp-Transistor T2 mit seiner Basis auf diesem Verbindungspunkt. Der Kollektor des Transistors T1 ist über einen Widerstand R2 auf die Anode der Diode D1 geführt. Der Emitter des Transistors T2 ist mit dem Gate des MOSFET T1 verbunden. Darüber hinaus ist das Gate des MOSFET T1 über einen Widerstand R3 auf die Anode der Diode D1 geführt.

Die in Fig. 1 als Blockdarstellung gezeigte Steuerschaltung 10 wird bei der hier gezeigten Ausführungsform der Erfindung somit aus den Bauelementen R1 bis R3, Z1, D4 und T2 gebildet. Die Wirkungsweise der Anordnung entspricht exakt derjenigen nach Fig. 1, wie dies sich dem Fachmann aufgrund der gezeigten Schaltung offenbart. Ein wesentlicher Vorteil dieser Schaltung liegt gegenüber dem Stand der Technik darin, daß keine potentialfreie, aufwendige Ansteuerung des Entladungsschalters notwendig ist.

**Ansprüche**

1. Elektrische Schaltung zur Ausschaltentlastung eines steuerbaren Halbleiterschalters (S1), insbesondere eines abschaltbaren Thyristors (GTO), mit einer zum Schalter (S1) parallelen Reihenschaltung aus einem Speicherkondensator (C1) und einer ersten Diode (D1) und einem, über eine Steuerschaltung (10) steuerbaren Entladungsschalter (S2), der in Reihe mit einer Primärwicklung (L1) eines Transformators (T) liegt, zum Schließen eines Entladungsstromkreises, der den Kondensator (C1) mit der Primärwicklung (L1) verbindet, so daß an einer Sekundärwicklung (L2) des Transformators (T) die im Kondensator (C1) gespeicherte Energie abnehmbar ist,
**dadurch gekennzeichnet,**
daß die Steuerschaltung (10) derart ausgebildet und mit der Diode (D1) eingangsseitig verbunden ist, daß der Entladungsschalter (S2) in Abhängigkeit von der Polarität der Spannung San der ersten Diode (D1) geschaltet wird.
2. Schaltung nach Anspruch 1,
**dadurch gekennzeichnet,**
daß die Reihenschaltung aus Entladungsschalter (S2) und Primärwicklung (L1) parallel zur ersten Diode (D1) geschaltet ist, so daß der Entladestrom des Kondensators (C1) durch den steuerbaren Schalter (S1) fließt.
3. Schaltung nach einem der vorhergehenden Ansprüche,
**dadurch gekennzeichnet,** daß der Transformator (T1) als Sperrwandler ausgebildet bzw. beschaltet ist.
4. Schaltung nach einem der vorhergehenden Ansprüche,
**dadurch gekennzeichnet,**
daß der Entladungsschalter (S2) einen Transistor (T1), vorzugsweise einen MOSFET umfaßt.
5. Schaltung nach Anspruch 4,
**dadurch gekennzeichnet,**
daß die Steuerschaltung (10) umfaßt:
eine Zenerdiode (Z1), die mit ihrer Anode an der Anode der ersten Diode (D1) und mit ihrer Kathode über einen Widerstand (R1) an der Kathode der ersten Diode (D1) liegt; einen pnp-Transistor (T2), der mit seinem Kollektor über einen Widerstand (R2) mit der Anode der Zenerdiode (Z1), mit seiner Basis an der Kathode der Zenerdiode (Z1) und mit seinem Emitter einerseits am Steuereingang des Transistors (T1) andererseits über die Kathoden-Anoden-Strecke einer zweiten Diode (D2) an der Kathode der Zenerdiode (Z1) liegt;

einen Widerstand (R3), der den Steuereingang des Transistors (T1) mit der Anode der ersten Diode (D1) verbindet.

Fig. 1

Fig. 2

5